# EUROPÄISCHE PATENTSCHRIFT

(11) **EP 2 951 861 B1**
(45) Veröffentlichungstag und Bekanntmachung des Hinweises auf die Patenterteilung: **28.10.2020**
(21) Anmeldenummer: 14704295.6
(22) Anmeldetag: 22.01.2014
(51) Int. Cl.: H01L 23/488, H01L 25/065, B23K 1/005, B23K 1/00, H01L 23/00, H01L 25/00, B23K 26/14, B23K 101/42

(54) **VERFAHREN ZUR HERSTELLUNG EINER CHIPANORDNUNG**
METHOD FOR PRODUCING A CHIP ASSEMBLY
PROCÉDÉ DE FABRICATION D'UN ENSEMBLE DE PUCES SEMI-CONDUCTRICES

(30) Priorität: 31.01.2013 DE 102013001642
(43) Veröffentlichungstag der Anmeldung: 09.12.2015
(73) Patentinhaber: Pac Tech - Packaging Technologies GmbH, 14641 Nauen (DE)
(72) Erfinder: AZDASHT, Ghassem, 13591 Berlin (DE)
(74) Vertreter: advotec.
(86) Internationale Anmeldenummer: PCT/EP2014/051194
(87) Internationale Veröffentlichungsnummer: WO 2014/118044

(56) Entgegenhaltungen:
- WO-A1-2007/056997
- JP-A- 62 293 750
- KR-A- 20110 107 125
- US-A- 5 963 793
- US-A- 6 140 696

## Beschreibung

Die vorliegende Erfindung betrifft ein Verfahren zur Herstellung einer Chipanordnung nach dem Oberbegriff des Anspruchs 1.

Mit der zunehmenden Miniaturisierung von elektronischen Geräten nehmen auch die Anforderungen an die Integrationsdichte der darin verwendeten elektronischen Bausteine zu. In besonderem Maße betrifft dies Speicherbausteine oder Speichererweiterungen, die in der Regel aus einer Mehrzahl von Speicherchips zusammengesetzt sind, welche über ein gemeinsames Kontaktsubstrat elektrisch kontaktiert sind.

Aus der DE 196 26 126 A1 ist eine in **Fig. 1** schematisch dargestellte Chipanordnung bekannt, die als Stapelanordnung sandwichartig aufgebaut ist, mit einer alternierenden Anordnung von Chips 1 und zwischenliegend angeordneten Kleberschichten 2, die einerseits für einen mechanischen Zusammenhalt der Stapelanordnung sorgen und andererseits eine definierte Beabstandung der einzelnen Chips 1 voneinander ermöglichen. Seitlich der Stapelanordnung von Chips sind Kontaktleitersubstrate 3 vorgesehen, die mit einzelnen Leiterbahnen 4 versehen sind, welche eine elektrische Kontaktierung von Anschlussflächen 5 der Chips 1 mit die Stapelanordnung nach oben und unten jeweils begrenzenden Anschlusssubstraten 6 ermöglichen, deren Anschlusskontakte 7 zur äußeren Kontaktierung der Chipanordnung dienen. Zur Herstellung eines elektrischen Kontakts zwischen den Anschlussflächen 5 der Chips 1 und den Leiterbahnen 4 der Kontaktleitersubstrate 3 sind Lotverbindungen 8 vorgesehen.

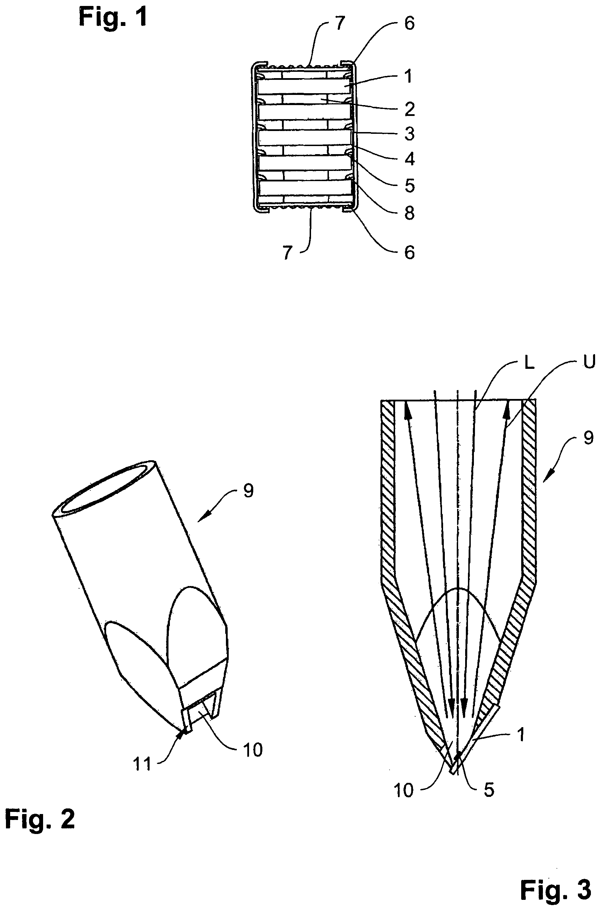

In Anbetracht des komplexen Aufbaus der in **Fig. 1** dargestellten Chipanordnung ist offensichtlich, dass auch die Herstellung der Chipanordnung entsprechend aufwendig ist, mit einer Vielzahl aufeinanderfolgender Verfahrensschritte, die zur Herstellung der Stapelanordnung mit den übereinanderliegend angeordneten und durch Kleberschichten 2 voneinander getrennten Chips 1 und zur Herstellung der Lotverbindungen 8 zwischen den Anschlussflächen 5 des Chips 1 und den Leiterbahnen 4 der Kontaktleitersubstrate 3 die Verwendung unterschiedlicher Werkzeuge erforderlich machen.

Aus der US 5 963 793 A ist ein Verfahren zur Herstellung einer Chipanordnung mit einem Anschlusssubstrat und einer Mehrzahl auf dem Anschlusssubstrat angeordneten Halbleitersubstraten bekannt, bei dem die Halbleitersubstrate zur manuellen Positionierung auf einem Anschlusssubstrat mit einem Kleberauftrag versehen und mit dem Anschlusssubstrat verbunden werden. Nachfolgend der Klebeverbindung zwischen dem Halbleitersubstrat und dem Anschlusssubstrat erfolgt zur Herstellung einer Lotverbindung zwischen Anschlussflächen des Halbleitersubstrats und Anschlussflächen des Anschlusssubstrats die Durchführung eines Reflow-Verfahrens.

Aus der KR 2011 0107125 A ist eine Chipanordnung mit einem Anschlusssubstrat und einer Mehrzahl auf dem Anschlusssubstrat angeordneten Halbleitersubstraten bekannt, wobei die Halbleitersubstrate über eine Seitenkante mit dem Anschlusssubstrat verbunden sind, und zur elektrischen Kontaktierung von Anschlussflächen der Halbleitersubstrate mit Anschlussflächen des Anschlusssubstrats eine Lotverbindung vorgesehen ist.

Die WO 2007/056997 A1 zeigt ein Verfahren zur Herstellung einer Chipanordnung mit einem Anschlusssubstrat und einem Halbleitersubstrat, bei dem zur mechanischen Verbindung des Halbleitersubstrats mit dem Anschlusssubstrat eine auf dem Anschlusssubstrat aufgebrachte Kleberschicht dient, und eine elektrische Kontaktierung von Anschlussflächen des Halbleitersubstrats mit Anschlussflächen des Anschlusssubstrats über eine Lotverbindung erfolgt. Zur Herstellung der Lotverbindung erfolgt eine Positionierung des Halbleitersubstrats gegenüber dem Anschlusssubstrat derart, dass die Lotverbindung durch Aufschmelzen von auf den Anschlussflächen des Halbleitersubstrats angeordneten Lotmaterialdepots hergestellt wird. Während der Erstarrung des Lotmaterials der Lotmaterialverbindung wird das Halbleitersubstrat vermittelt der auf dem Anschlusssubstrat angeordneten Kleberschicht auf dem Anschlusssubstrat gehalten.

Ausgehend vom Stand der Technik liegt der Erfindung die Aufgabe zugrunde, ein Verfahren vorzuschlagen, das die einfache Herstellung einer Chipanordnung ermöglicht.

Diese Aufgabe wird durch ein Verfahren zur Herstellung einer Chipanordnung mit den Merkmalen des Anspruchs 1 gelöst.

Bei dem erfindungsgemäßen Verfahren zur Herstellung einer Chipanordnung mit einem Anschlusssubstrat und einer Mehrzahl auf dem Anschlusssubstrat angeordneter Halbleitersubstrate, insbesondere Chips, wobei auf einer Kontaktoberfläche der Halbleitersubstrate angeordnete Anschlussflächen mit Anschlussflächen auf einer Kontaktoberfläche des Anschlusssubstrats verbunden sind, werden die Halbleitersubstrate mit einer Seitenkante parallel und mit ihrer Kontaktoberfläche quer zur Kontaktoberfläche des Anschlusssubstrats positioniert, derart, dass benachbart der Seitenkante angeordnete Anschlussflächen der Halbleitersubstrate den Innenkontakte ausbildenden Anschlussflächen des Anschlusssubstrats zugeordnet sind, welche über im Anschlusssubstrat ausgebildete Durchkontaktierungen mit auf einer Außenkontaktseite des Anschlusssubstrats angeordneten Außenkontakten verbunden sind, und nachfolgend erfolgt eine Verbindung der Innenkontakte mit den Anschlussflächen mittels umgeschmolzener Lotmaterialdepots.

Erfindungsgemäß erfolgt die Positionierung der Halbleitersubstrate auf der Kontaktoberfläche des Anschlusssubstrats mittels eines Bestückungswerkzeugs derart, dass die Halbleitersubstrate von dem Bestückungswerkzeug erfasst, entsprechend der gewünschten Position zum Anschlusssubstrat ausgerichtet und in dieser Position gehalten werden. Erfindungsgemäß erfolgt das Umschmelzen der Lotmaterialdepots zur Herstellung der Verbindung zwischen den Innenkontakten des Anschlusssubstrats und den Anschlussflächen des Halbleitersubstrats während der Positionierung des Chips, sodass das Positionieren und Umschmelzen in einem gemeinsamen Verfahrensschritt erfolgen kann.

Erfindungsgemäß erfolgt die Positionierung der Chips auf der Kontaktoberfläche des Anschlusssubstrats und die Verbindung der Anschlussflächen der Chips mit den Innenkontakten des Anschlusssubstrats sukzessive, derart, dass in einer Bestückungsrichtung parallel zur Kontaktoberfläche des Anschlusssubstrats ein Chip nach dem anderen positioniert und mit dem Anschlusssubstrat verbunden wird, sodass die Halbleitersubstrate nach dem erfolgten Aufschmelzen der Lotmaterialdepots bis zu einem Wiedererstarren des Lotmaterials von dem Bestückungswerkzeug gehalten werden.

Erfindungsgemäß werden die Halbleitersubstrate so positioniert gehalten, dass zwischen der Seitenkant der Halbleitersubstrate und der Kontaktoberfläche des Anschlusssubstrats ein Füllspalt ausgebildet ist, der nach Fertigstellung der Reihenanordnung von Halbleitersubstraten mit einem Vergussmaterial verfüllt wird.

Wenn zur Herstellung der Verbindung zwischen den Anschlussflächen des Chips und den Innenkontakten des Anschlusssubstrats eine Anordnung von Lotmaterialdepots auf den Innenkontakten des Anschlusssubstrats erfolgt, kann auf eine Applikation von Lotmaterial auf die Mehrzahl von Chips verzichtet werden. Vielmehr ist eine Applikation von Lotmaterialdepots lediglich auf die Innenkontakte des Anschlusssubstrats notwendig, welches sich dabei darüber hinaus bereits in der für die Bestückung mit Halbleitersubstraten geeigneten Position befinden kann.

Wenn die Anordnung der Lotmaterialdepots auf den Innenkontakten des Anschlusssubstrats vor der Positionierung der Halbleitersubstrate auf der Kontaktoberfläche des Anschlusssubstrats erfolgt, wird die Lotmaterialapplikation nicht durch bereits positionierte Halbleitersubstrate behindert.

Besonders bevorzugt ist es, wenn die Positionierung der Halbleitersubstrate derart erfolgt, dass die Innenkontakte des Anschlusssubstrats und die Anschlussflächen der Chips so zueinander angeordnet sind, dass zwischen ihnen ein Eckenwinkel α ausgebildet ist.

Vorzugsweise erfolgt das Halten der Chips mittels Unterdruck. Vorzugsweise erfolgt das Umschmelzen der Lotmaterialdepots mittels Laserenergie, derart, dass die Beaufschlagung des Lotmaterialdepots mit Laserstrahlung durch das Bestückungswerkzeug hindurch erfolgt. Nachfolgend wird die Erfindung anhand der Zeichnungen näher erläutert, wobei insbesondere das Verfahren zur Herstellung der erfindungsgemäßen Chipanordnung näher erläutert wird.

Es zeigen:
- **Fig. 1:**: eine dem Stand der Technik entsprechende Chipanordnung;
- **Fig. 2:**: ein Ausführungsbeispiel eines zur Herstellung einer Chipanordnung geeigneten Bestückungswerkzeuges;
- **Fig. 3:**: eine Längsschnittdarstellung des Bestückungswerkzeuges;
- **Fig. 4:**: ein Anschlusssubstrat einer Chipanordnung;
- **Fig. 5:**: die Positionierung eines Chips auf dem in **Fig. 4** dargestellten Anschlusssubstrat;
- **Fig. 6:**: die in Bestückungsrichtung fortlaufende Positionierung von Chips auf dem Anschlusssubstrat;
- **Fig. 7:**: eine mit einem Verguss versehene Chipanordnung.

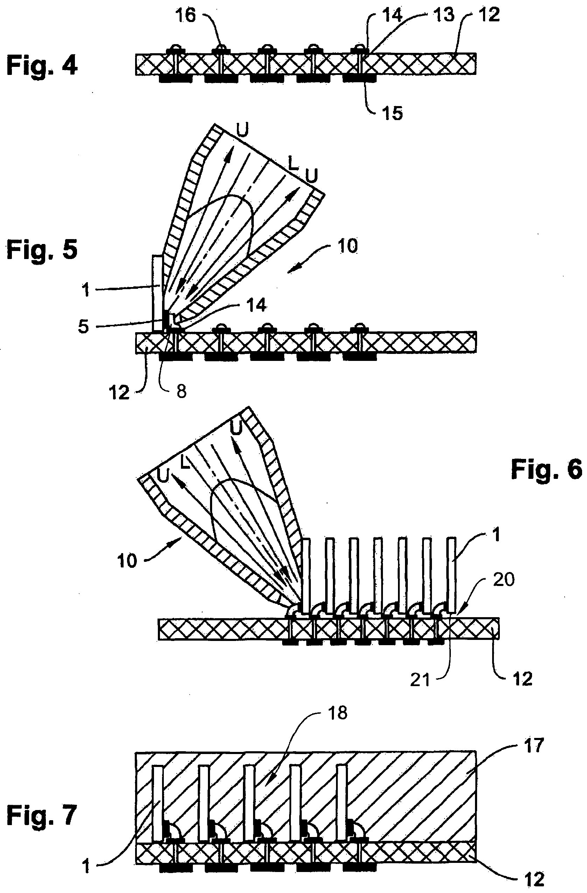

In den **Fig. 4 bis 7** sind aufeinanderfolgende Verfahrensschritte zur Herstellung einer Chipanordnung 18 dargestellt, die zur Ausbildung einer Gehäusung mit einem Vergussmaterial 17 versehen ist, wobei zunächst eine Bereitstellung eines in **Fig. 4** dargestellten Anschlusssubstrats 12 erfolgt, welches mit Durchkontaktierungen 13 zur Herstellung einer elektrisch leitenden Verbindung zwischen Innenkontakten 14, die auf einer Kontaktoberfläche des Anschlusssubstrats 12 angeordnet sind, und Außenkontakten 15, die auf einer Außenkontaktseite des Anschlusssubstrats 12 angeordnet sind, versehen ist.

In den **Fig. 2 und 3** ist ein zur Herstellung der in **Fig. 7** dargestellten Chipanordnung 18 verwendetes Bestückungswerkzeug 9 in isometrischer Darstellung und im Schnitt dargestellt. Das Bestückungswerkzeug 9 weist am Ende eines Kanals eine Fensteröffnung 10 auf mit einem Positionierungsrahmen 11, der, wie **Fig. 3****,** zeigt die exakte Positionierung eines Chips 1 in der Fensteröffnung 10 ermöglicht. Der Kanal des Bestückungswerkzeugs 9 ermöglicht sowohl eine Beaufschlagung des in dem Positionierungsrahmen 11 aufgenommenen Chips 1 mit Unterdruck U als auch eine Beaufschlagung des Chips 1 mit Laserstrahlung L.

Der Unterdruck U ermöglicht ein fixiertes Halten des Chips 1 an dem Positionierungsrahmen 11. Die Beaufschlagung des Chips 1 mit Laserstrahlung L ermöglicht ein definiertes Aufheizen des Siliziumkörpers des Chips 1 und somit auch von auf einer Kontaktoberfläche des Chips 1 angeordneten Anschlussflächen 5.

Wie **Fig. 4** zeigt, werden die Innenkontakte 14 des Kontaktsubstrats 12 zur Vorbereitung einer nachfolgenden Kontaktierung mit den Anschlussflächen 5 der Chips 1 mit einem Lotmaterialdepot 16 versehen.

Anschließend wird, wie in den **Fig. 5 und 6** dargestellt, beginnend mit einem an einem Rand des Anschlusssubstrats 12 angeordneten Chip 1 eine aufeinanderfolgende Kontaktierung einzelner Chips 1 durchgeführt, wobei mit dem Bestückungswerkzeug 9 jeder einzelne Chip 1 mittels Unterdruck U erfasst und entsprechend seiner gewünschten Position zum Anschlusssubstrat 12 ausgerichtet wird, derart, dass die Innenkontakte 14 und die Anschlussflächen 5 so zueinander angeordnet werden, dass sie Raumecken ausbilden, wobei im vorliegenden Fall ein jeweils zwischen den Innenkontakten 14 und den Anschlussflächen 5 ausgebildeter Eckenwinkel α von 90° ausgebildet wird. In dieser Relativposition erfolgt ein zumindest partielles Aufschmelzen des Lotmaterialdepots 16 mittels einer die Laserstrahlung L emittierenden Energiequelle, so dass nach einem kurzzeitigen Aufschmelzen eine rasche Erstarrung einer aus dem Lotmaterialdepot 16 gebildeten Lotverbindung 8 erfolgt.

Anschließend werden, wie in **Fig. 6** dargestellt, zur Ausbildung einer Reihenanordnung von Chips 1 nacheinander fortschreitend die weiteren Chips 1 mittels des Bestückungswerkzeugs 9 positioniert und kontaktiert. Die Chips 1 werden dabei so positioniert, dass zwischen einer Seitenkante 21 der Chips und der Kontaktoberfläche des Anschlusssubstrats 12 ein Füllspalt 20 ausgebildet ist, der, wie aus **Fig. 7** ersichtlich, nach Fertigstellung der Reihenanordnung von Chips 1 mit dem Vergussmaterial 17 verfüllt wird.

Das Bestückungswerkzeug 9 ermöglicht somit sowohl ein definiertes Positionieren der Chips 1 auf dem Anschlusssubstrat 12 als auch ein Aufschmelzen der Lotmaterialdepots 16 zur Herstellung der Lotverbindung 8 zwischen den Innenkontakten 14 des Anschlusssubstrats 12 und den Anschlussflächen 5 der Chips 1. Somit erfolgt die Anordnung der Chips 1 auf dem Anschlusssubstrat 12 und die Herstellung der elektrisch leitfähigen Verbindung durch Aufschmelzen der Lotmaterialdepots 16 zur Ausbildung der Lotverbindungen 8 in einem gemeinsamen Verfahrensschritt und nicht aufeinanderfolgend mittels zweier unterschiedlicher Werkzeuge, wie es bei dem Bezug nehmend auf **Fig. 1** geschilderten Stand der Technik der Fall ist.

Wie **Fig. 6** zeigt, werden nacheinander sämtliche Chips 1 auf dem Anschlusssubstrat 12 angeordnet und elektrisch leitfähig mit dem Anschlusssubstrat 12 verbunden, wobei die Chips 1 nach dem erfolgten Aufschmelzen der Lotmaterialdepots 16 bis zu einem Wiedererstarren des Lotmaterials als Lotverbindung 8 von dem Bestückungswerkzeug 9 gehalten werden, so dass keine zwischen den einzelnen Chips 1 angeordneten Kleberschichten 2 zur Fixierung der Relativanordnung der Chips 1 erforderlich sind, wie es bei dem in **Fig. 1** dargestellten Stand der Technik der Fall ist.

Nach vollständiger Bestückung des Anschlusssubstrats 12 mit der gewünschten Anzahl von Chips 1 kann nun, wie in **Fig. 7** dargestellt, durch das Vergussmaterial 17, das auf das Anschlusssubstrat 12 aufgebracht wird, ein hermetisch abgeschlossener, gegen äußere Einflüsse abgeschirmter Verbund der Chips 1 mit dem Anschlusssubstrat 12 hergestellt werden.

## Patentansprüche

1. Verfahren zur Herstellung einer Chipanordnung (18) mit einem Anschlusssubstrat (12) und einer Mehrzahl auf dem Anschlusssubstrat angeordneter Halbleitersubstrate, insbesondere Chips (1), wobei auf einer Kontaktoberfläche der Halbleitersubstrate angeordnete Anschlussflächen (5) mit Anschlussflächen auf einer Kontaktoberfläche des Anschlusssubstrats verbunden sind, wobei die Halbleitersubstrate mit einer Seitenkante (21) parallel und mit ihrer Kontaktoberfläche quer zur Kontaktoberfläche des Anschlusssubstrats positioniert werden, derart, dass benachbart der Seitenkante angeordnete Anschlussflächen der Halbleitersubstrate den Innenkontakte (14) ausbildenden Anschlussflächen des Anschlusssubstrats zugeordnet sind, welche über im Anschlusssubstrat ausgebildete Durchkontaktierungen (13) mit auf einer Außenkontaktseite des Anschlusssubstrats angeordneten Außenkontakten (15) verbunden sind, und nachfolgend eine Verbindung der Innenkontakte mit den Anschlussflächen mittels umgeschmolzener Lotmaterialdepots (16) erfolgt,
**dadurch gekennzeichnet,**
**dass** die Positionierung der Halbleitersubstrate auf der Kontaktoberfläche des Anschlusssubstrats (12) mittels eines Bestückungswerkzeugs (9) erfolgt, derart, dass die Halbleitersubstrate von dem Bestückungswerkzeug erfasst, entsprechend der gewünschten Position zum Anschlusssubstrat ausgerichtet und in dieser Position gehalten werden,
und **dass** das Umschmelzen der Lotmaterialdepots (16) zur Herstellung einer Lotverbindung (8) zwischen den Innenkontakten (14) des Anschlusssubstrats (12) und den Anschlussflächen (5) des Halbleitersubstrats während der Positionierung des Halbleitersubstrats erfolgt,
und **dass** die Positionierung der Mehrzahl von Halbleitersubstraten auf der Kontaktoberfläche des Anschlusssubstrats (12) und die Verbindung der Anschlussflächen (5) der Halbleitersubstrate mit den Innenkontakten (14) des Anschlusssubstrats (12) sukzessive erfolgt, derart, dass in einer Bestückungsrichtung parallel zur Kontaktoberfläche des Anschlusssubstrats ein Halbleitersubstrat nach dem anderen in einer Reihenanordnung positioniert und mit dem Anschlusssubstrat verbunden wird,
wobei die Halbleitersubstrate nach dem erfolgten Aufschmelzen der Lotmaterialdepots (16) bis zu einem Wiedererstarren des Lotmaterials von dem Bestückungswerkzeug gehalten werden,
und wobei die Halbleitersubstrate derart positioniert gehalten werden, dass zwischen der Seitenkante (21) der Halbleitersubstrate und der Kontaktoberfläche des Anschlusssubstrats (12) ein Füllspalt (20) ausgebildet ist, der nach Fertigstellung der Reihenanordnung von Halbleitersubstraten mit einem Vergussmaterial (17) verfüllt wird.

2. Verfahren nach Anspruch 1,
**dadurch gekennzeichnet,**
**dass** vor Herstellung der Verbindung zwischen den Anschlussflächen (5) des Halbleitersubstrats und den Innenkontakten (14) des Anschlusssubstrats (12) eine Anordnung der Lotmaterialdepots (16) auf den Innenkontakten des Anschlusssubstrats erfolgt.

3. Verfahren nach Anspruch 2,
**dadurch gekennzeichnet,**
**dass** die Anordnung der Lotmaterialdepots (16) auf den Innenkontakten (14) des Anschlusssubstrats (12) vor der Positionierung der Halbleitersubstrate auf der Kontaktoberfläche des Anschlusssubstrats erfolgt.

4. Verfahren nach einem der Ansprüche 1 bis 3, **dadurch gekennzeichnet,**
**dass** die Positionierung der Halbleitersubstrate derart erfolgt, dass die Innenkontakte (14) des Anschlusssubstrats (12) und die Anschlussflächen (5) der Halbleitersubstrate so zueinander angeordnet sind, dass zwischen ihnen ein Eckenwinkel α ausgebildet ist.

5. Verfahren nach einem der Ansprüche 1 bis 4, **dadurch gekennzeichnet,**
**dass** das Halten der Halbleitersubstrate mittels Unterdruck erfolgt.

6. Verfahren nach einem der Ansprüche 1 bis 5, **dadurch gekennzeichnet,**
**dass** das Umschmelzen der Lotmaterialdepots (16) mittels Laserenergie erfolgt.

7. Verfahren nach Anspruch 6, **dadurch gekennzeichnet,**
**dass** die Beaufschlagung der Lotmaterialdepots (16) mit Laserstrahlung durch das Bestückungswerkzeug (9) hindurch erfolgt.

## Claims

1. A method for producing a chip arrangement (18) comprising a terminal substrate (12) and a plurality of semiconductor substrates, in particular chips (1), which are arranged on the terminal substrate, wherein terminal faces (5) arranged on a contact surface of the semiconductor substrates are connected to terminal faces on a contact surface of the terminal substrate, wherein the semiconductor substrates are positioned parallel with a lateral edge (21) and transversally with their contact surface to the contact surface of the terminal substrate in such a manner that terminal faces of the semiconductor substrates which are arranged adjacent to the lateral edge are assigned to the terminal faces of the terminal substrate, which form internal contacts (14), said terminal faces being connected to external contacts (15) arranged on an external contact side of the terminal substrate by means of vias (13) formed in the terminal substrate, and the internal contacts are subsequently connected to the terminal faces by way of re-melted solder material deposits (16),
**characterised in that**
the semiconductor substrates are positioned on the contact surface of the terminal substrate (12) by means of a placement tool (9), the semiconductor substrates being picked up by the placement tool, being oriented in correspondence to the desired position towards the terminal substrate, and being held in said position,
and **in that** the re-melting of the solder material deposits (16) for producing a solder connection (8) between the internal contacts (14) of the terminal substrate (12) and the terminal faces (5) of the semiconductor substrate (1) takes place while the semiconductor substrate is being positioned,
and **in that** the positioning of the plurality of the semiconductor substrates on the contact surface of the terminal substrate (12) and the connection of the terminal faces (5) of the semiconductor substrates to the internal contacts (14) of the terminal substrate (12) take place successively, one semiconductor substrate after another being positioned in a row arrangement in a placement direction parallel to the contact surface of the terminal substrate and being connected to the terminal substrate,
wherein the semiconductor substrates are held by the placement tool following the re-melting of the solder material deposits (16) until the solder material has solidified,
and wherein the semiconductor substrates are held in position in such a manner that a filling gap (20) is formed between the lateral edge (21) of the semiconductor substrates and the contact surface of the terminal substrate (12), said filling gap being filled with a moulding material (17) once the row arrangement of semiconductor substrates has been completed.

2. The method according to claim 1,
**characterised in that**
prior to the production of the connection between the terminal faces (5) of the semiconductor substrate and the internal contacts (14) of the terminal substrate (12), the solder material deposits (16) are arranged on the internal contacts of the terminal substrate.

3. The method according to claim 2,
**characterised in that**
the arrangement of the solder material deposits (16) on the internal contacts (14) of the terminal substrate (12) takes place before the semiconductor substrates are positioned on the contact surface of the terminal substrate.

4. The method according to any of claims 1 to 3,
**characterised in that**
the semiconductor substrates are positioned in such a manner that the internal contacts (14) of the terminal substrate (12) and the terminal faces (5) of the semiconductor substrates are arranged relative to one another in such a manner that a corner angle α is formed between them.

5. The method according to any of claims 1 to 4,
**characterised in that**
the semiconductor substrates are held by means of negative pressure.

6. The method according to any of claims 1 to 5,
**characterised in that**
the solder material deposits (16) are re-melted by means of laser energy.

7. The method according to claim 6,
**characterised in that**
the solder material deposits (16) are impinged with laser radiation passing through the placement tool (9).

## Revendications

1. Procédé de production d'un ensemble de puces (18) comprenant un substrat de connexion (12) et une pluralité de substrats semi-conducteurs, notamment des puces (1), qui sont disposés sur le substrat de connexion, des faces de connexion (5) disposées sur une surface de contact des substrats semi-conducteurs étant connectées à des faces de connexion sur une surface de contact du substrat de connexion, un bord latéral (21) des substrats semi-conducteurs étant positionné parallèlement et la surface de contact des substrats semi-conducteurs étant positionnée perpendiculairement à la surface de contact du substrat de connexion de telle manière que des faces de connexion des substrats semi-conducteurs qui sont disposées de manière adjacente au bord latéral sont assignées aux faces de connexion du substrat de connexion qui forment des contacts intérieurs (14) et qui sont connectées à des contacts extérieurs (15) disposés sur un côté de contact extérieur du substrat de connexion à travers des vias (13) formés dans le substrat de connexion, et les contacts intérieurs sont ensuite connectés aux faces de connexion au moyen de dépôts de matière de brasage (16) refondus,
**caractérisé en ce que**
les substrats semi-conducteurs (1) sont positionnés sur la surface de contact du substrat de connexion (12) au moyen d'un outil de placement (9), les substrats semi-conducteurs étant saisis par l'outil de placement, étant alignés conformément à la position désirée par rapport au substrat de connexion et étant tenus dans cette position, et **en ce que** la refusion des dépôts de matière de brasage (16) pour la production d'une brasure (8) entre les contacts intérieurs (14) du substrat de connexion (12) et les faces de connexion (5) du substrat semi-conducteur (1) s'effectue lors du positionnement du substrat semi-conducteur,
et **en ce que** le positionnement de la pluralité de substrats semi-conducteurs sur la surface de contact du substrat de connexion (12) et la connexion des faces de connexion (5) des substrats semi-conducteurs aux contacts intérieurs (14) du substrat de connexion (12) s'effectuent successivement, les substrats semi-conducteurs étant positionnés en une rangée dans une direction de placement parallèle à la surface de contact du substrat de connexion et étant connectés au substrat de connexion un par un,
les substrats semi-conducteurs étant tenus par l'outil de placement après la refusion des dépôts de matière de brasage (16) jusqu'à ce que la matière de brasage se soit solidifiée,
et les substrats semi-conducteurs étant maintenus en position de telle manière qu'une fente de remplissage (20) est formée entre le bord latéral (21) des substrats semi-conducteurs et la surface de contact du substrat de connexion (12), ladite fente de remplissage étant remplie d'une matière de scellement (17) une fois le positionnement en rangée des substrats semi-conducteurs terminé.

2. Procédé selon la revendication 1,
**caractérisé en ce**
**qu'**avant la production de la connexion entre les faces de connexion (5) du substrat semi-conducteur et les contacts intérieurs (14) du substrat de connexion (12), les dépôts de matière de brasage (16) sont disposés sur les contacts intérieurs du substrat de connexion.

3. Procédé selon la revendication 2,
**caractérisé en ce que**
la disposition des dépôts de matière de brasage (16) sur les contacts intérieurs (14) du substrat de connexion (12) s'effectue avant le positionnement des substrats semi-conducteurs sur la surface de contact du substrat de connexion.

4. Procédé selon l'une quelconque des revendications 1 à 3,
**caractérisé en ce que**
les substrats semi-conducteurs sont positionnés de telle manière que les contacts intérieurs (14) du substrat de connexion (12) et les faces de connexion (5) des substrats semi-conducteurs sont disposés l'un par rapport à l'autre de telle manière qu'un angle de coin α est formé entre eux.

5. Procédé selon l'une quelconque des revendications 1 à 4,
**caractérisé en ce que**
les substrats semi-conducteurs sont tenus par vide.

6. Procédé selon l'une quelconque des revendications 1 à 5,
**caractérisé en ce que**
les dépôts de matière de brasage (16) sont refondus par énergie laser.

7. Procédé selon la revendication 6,
**caractérisé en ce que**
les dépôts de matière de brasage (16) sont irradiés par laser à travers l'outil de placement (9).
